Europäisches Patentamt

European Patent Office

Office européen des brevets

(11) Numéro de publication: **0 129 056**

**A1**

## (12) DEMANDE DE BREVET EUROPEEN

(21) Numéro de dépôt: **84105486.9**

(22) Date de dépôt: **15.05.84**

(51) Int. Cl.³: **H 05 K 7/18**
**F 16 B 12/50**

(30) Priorité: **20.05.83 FR 8308358**

(43) Date de publication de la demande:
**27.12.84 Bulletin 84/52**

(84) Etats contractants désignés:
**BE DE FR GB IT LU NL**

(71) Demandeur: **CGEE ALSTHOM Société anonyme dite:**
**13, rue Antonin Raynaud**
**F-92309 Levallois-Perret(FR)**

(72) Inventeur: **Guglieri, Henri Michel**
**5, rue des Tilleuls**
**F-91380 Chilly Mazarin(FR)**

(72) Inventeur: **Proudtchenko, Annick**
**8, avenue de Savoie**
**F-78140 Velizy-Villacoublay(FR)**

(74) Mandataire: **Weinmiller, Jürgen et al,**
**Zeppelinstrasse 63**
**D-8000 München 80(DE)**

(54) **Dispositif d'assemblage en coin pour bâtir une armoire pour équipement électrique et armoire assemblée avec ce dispositif.**

(57) Dispositif d'assemblage en coin, de deux traverses (5, 6) disposées perpendiculairement et d'un montant (2) perpendiculaire au plan formé par les deux traverses, au moyen d'un bloc d'assemblage (14), caractérisé en ce que l'une (6) des traverses s'emmanche dans une extrémité du bloc d'assemblage, l'autre (5) traverse s'emmanchant perpendiculairement dans une autre extrémité du bloc d'assemblage, ledit montant s'enfichant dans ledit bloc dans deux fentes (33, 34) dudit bloc, chaque fente ayant une forme d'équerre dont l'une des branches débouche à l'extérieur du bloc, la branche débouchant à l'extérieur du bloc, des deux fentes, débouchant respectivement sur deux parois perpendiculaire du bloc, la section dudit montant se composant, au niveau de son enfichage dans le bloc, de six côtés dont un premier côté (21) longe une face dudit bloc, un second côté (22), perpendiculaire au premier, longe une autre face dudit bloc, un troisième côté (23) perpendiculaire au second côté, un quatrième côté (24) perpendiculaire au troisième côté, les troisième et quatrième côtés pénétrant dans l'une (34) desdites fentes du bloc, un cinquième côté (25) adjacent au premier côté, du côté opposé au second côté, parallèle à ce second côté et un sixième côté (26) perpendiculaire au cinquième côté, les cinquième et sixième côtés pénétrant dans l'autre (33) desdites fentes du bloc, ladite section du montant réalisant un enchevêtrement au moins partiel avec chacune des deux traverses, l'ensemble étant maintenu au moyen de deux boulons (37, 38) dont l'un (38) pénètre dans une traverse (6), le bloc et ledit sixième côté )26) du montant et l'autre (37) pénètre dans l'autre traverse (5), le bloc et ledit quatrième côté (24) du montant.

./...

EP 0 129 056 A1

FIG.3

TITRE MODIFIÉ
voir page de garde

Dispositif d'assemblage en coin, de deux traverses disposées perpendiculairement et d'un montant perpendiculaire au plan formé par les deux traverses, et armoire dont l'ossature est assemblée conformément à ce dispositif.

La présente invention concerne un dispositif d'assemblage en coin, de deux traverses disposées perpendiculairement et d'un montant perpendiculaire au plan formé par les deux traverses, au moyen d'un bloc d'assemblage.

L'invention s'applique en particulier à la construction d'ossatures d'armoires, notamment d'armoires pour équipement électrique.

Le document FR-A n° 2 040 976 décrit un dispositif d'assemblage comprenant un bloc d'assemblage en forme d'équerre muni de différentes entailles permettant la fixation, aussi bien aux deux extrémités qu'en son milieu, de profilés.

Cependant, la solidarisation de l'ensemble par vissage qui n'est pas décrite nécessite en tout état de cause, pour la fixation de trois profilés sur un bloc d'assemblage au minimum trois vis ou boulons. Or, pour l'assemblage de grandes séries, on a le plus grand intérêt à diminuer le plus possible la boulonnerie. En effet, pour une armoire, par exemple, comportant huit angles, un assemblage conforme à celui décrit dans ce document nécessite au minimum vingt-quatre boulons rien que pour l'ossature.

La présente invention propose un dispositif d'assemblage solide, facilement démontable, nécessitant moins de boulons.

La présente invention a donc pour objet un dispositif d'assemblage en coin, de deux traverses disposées perpendiculairement et d'un montant perpendiculaire au plan formé par les deux traverses, au moyen d'un bloc d'assemblage, caractérisé en ce que l'une des traverses s'emmanche dans une extrémité du bloc d'assemblage, l'autre traverse s'emmanchant perpendiculairement dans une autre extrémité du bloc d'assemblage, ledit montant s'enfichant dans ledit bloc dans deux fentes dudit bloc, chaque fente ayant une forme d'équerre dont l'une des branches débouche à l'extérieur du bloc, la branche débouchant à l'extérieur du bloc, des deux fentes, débouchant respectivement sur deux parois perpendiculaires du bloc, la section dudit montant se composant, au niveau de son enfichage dans le bloc, de six côtés dont un premier côté longe une face dudit bloc, un second côté, perpendiculaire au premier, longe une autre face dudit bloc, un troisième côté perpendiculaire au second côté, un quatrième côté perpendiculaire au troisième côté, les troisième et quatrième côtés pénétrant dans l'une desdites fentes du bloc, un cinquième côté, adjacent au premier côté, du côté opposé au second côté, parallèle à ce second côté et un sixième côté perpendiculaire au cinquième côté, les cinquième et sixième côtés pénétrant dans l'autre desdites fentes du bloc, ladite section du montant réalisant un enchevêtrement au moins partiel avec chacune des deux traverses, l'ensemble étant maintenu au moyen de deux boulons dont l'un pénètre dans une traverse, le bloc et ledit sixième côté du montant et l'autre pénètre dans l'autre traverse, le bloc et ledit quatrième côté du montant.

Selon une première réalisation, ledit bloc d'assemblage comporte deux ailes perpendiculaires dans lesquelles viennent respectivement s'emmancher les deux dites traverses.

Selon une deuxième réalisation, ledit bloc d'assemblage a la forme générale d'un parallélépipède rectangle, l'une des traverses s'emmanchant en bout à l'une de ses extrémités et l'autre traverse s'emmanchant perpendiculairement à l'autre extrémité grâce à une fente pratiquée dans le bloc perpendiculairement à sa plus grande longueur.

L'invention a aussi pour objet une armoire comportant une ossature composée de huit traverses dont quatre de fronton et quatre de socle, de quatre montants verticaux et de huit blocs d'assemblage, caractérisée en ce que ladite ossature est assemblée conformément au dispositif d'assemblage ci-dessus.

On va maintenant donner la description d'un exemple de réalisation de l'invention en regard du dessin annexé dans lequel :

La figure 1 est une vue schématique montrant l'architecture de l'ossature d'une armoire dont chaque coin comporte le dispositif d'assemblage selon l'invention.

La figure 2 montre en perspective le détail de l'assemblage repéré II sur la figure 1.

La figure 3 représente le même détail que la figure 2 mais en

0129056

éclatée, avant l'assemblage des pièces.

La figure 4 montre en perspective le détail repéré IV sur la figure 1 c'est-à-dire le même assemblage que celui repéré II mais vu sous un autre angle.

La figure 5A représente en vue de dessus un coin d'assemblage tel que ceux figurant dans les parties repérées II ou IV sur la figure 1.

La figure 5B représente en vue de dessus un coin d'assemblage symétrique de celui de la figure 5A tel que ceux de la diagonale opposée à celle passant par les parties repérées II ou IV sur la figure 1.

Les figures 6, 7 et 8 représentent en perspective selon trois angles différents le coin d'assemblage tel que celui représenté figure 5A.

La figure 9 montre en vue de dessus, en coupe, l'assemblage représenté figure 2.

La figure 10 montre en vue de dessus un montant vertical.

La figure 11 est une vue de dessus de la figure 10.

La figure 12 est une section selon XII-XII de la figure 13, montrant la section d'une traverse horizontale.

La figure 13 est une vue de dessus de la figure 12.

La figure 14 représente une variante d'un bloc d'assemblage.

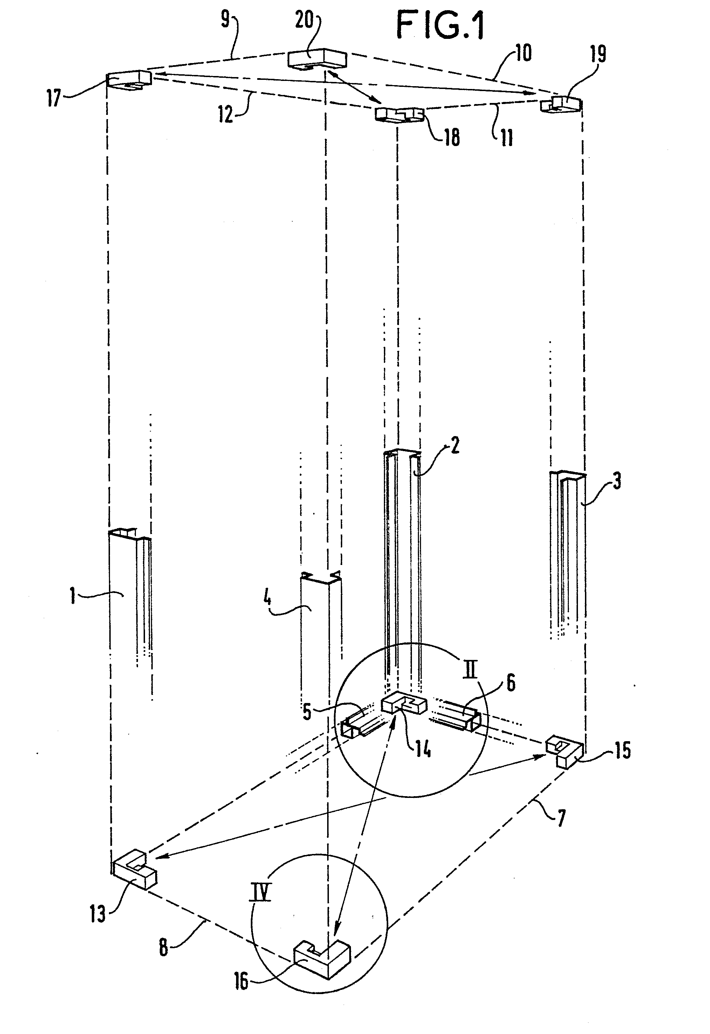

Comme le montre la figure 1, l'ossature de l'armoire selon l'invention se compose de quatre montants verticaux 1 à 4, de huit traverses horizontales 5 à 12 et de huit coins d'assemblage 13 à 20.

Seules les traverses 5 et 6 de socle ont été partiellement représentées, les autres traverses de socle 7 et 8 et les traverses 9 à 12 de fronton n'ont été que figurées par des traits interrompus fins.

L'ensemble est habillé par des panneaux latéraux, une porte, un plafond et un fond non représentés.

Les quatre montants verticaux 1 à 4 sont identiques, seul diffère le sens dans lequel ils sont placés.

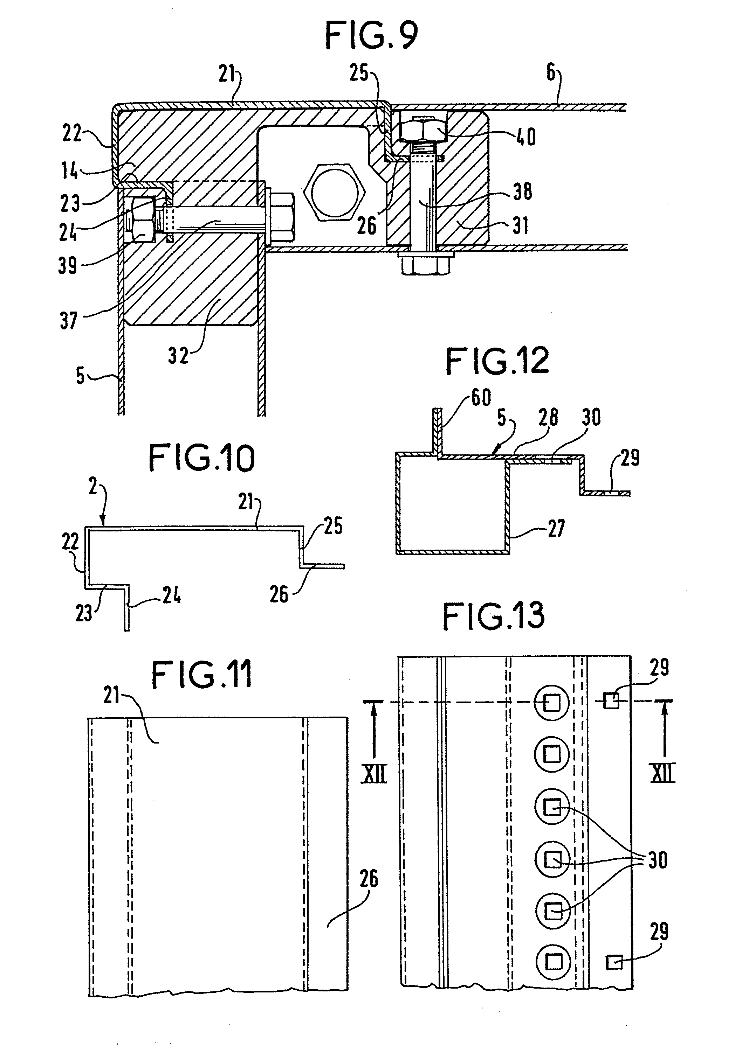

La figure 10 montre en vue de dessus un montant vertical dans le sens correspondant à celui repéré 2 sur la figure 1. Ce montant vertical comprend six côtés : un premier côté 21, un deuxième côté 22, un troisième côté 23, un quatrième côté 24, un cinquième côté 25 et un sixième côté 26.

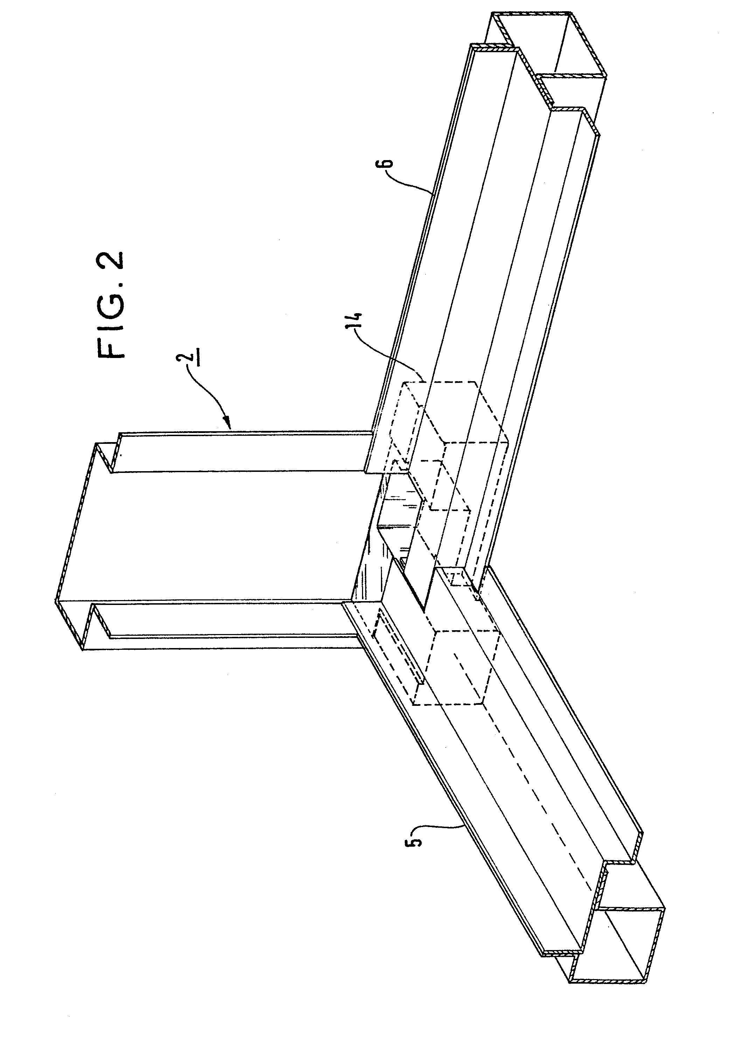

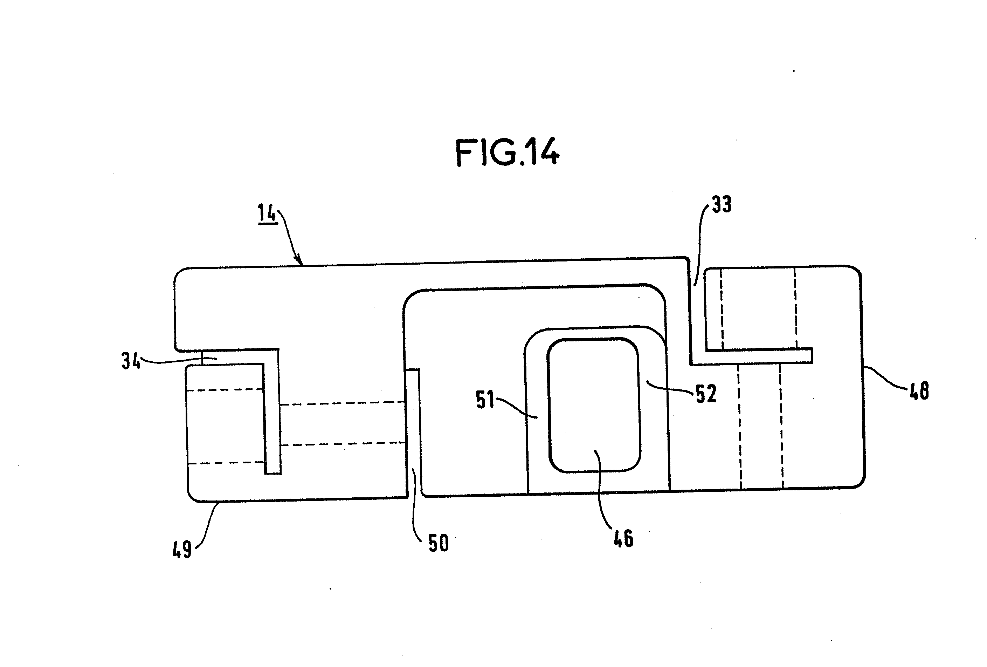

Les huit traverses horizontales 5 à 12 sont également identiques. Les figures 12 et 13 montrent une telle traverse dans une position correspondant à la traverse 5 figures 1, 2 et 3.

Une telle traverse est formée de deux tôles pliées et soudées 27 et 28 constituant un profil creux fermé. Des perforations 29 sont prévues pour la fixation du fond ou du plafond. De même, des trous 30 sont prévus pour la fixation des montants ou cadres d'équipement à l'intérieur de l'armoire. Le profil d'une traverse peut également être réalisé avec une seule tôle pliée et écrasée en 60. Le profil creux des traverses permet éventuellement d'y insérer des tubes de renfort.

Les traverses 9 à 12 de fronton sont dans un sens inverse, en retournant la figure 12 de bas en haut.

Les coins 14, 16, 17 et 19 sont identiques et les quatre autres coins 13, 15, 18 et 20 sont symétriques des quatre premiers.

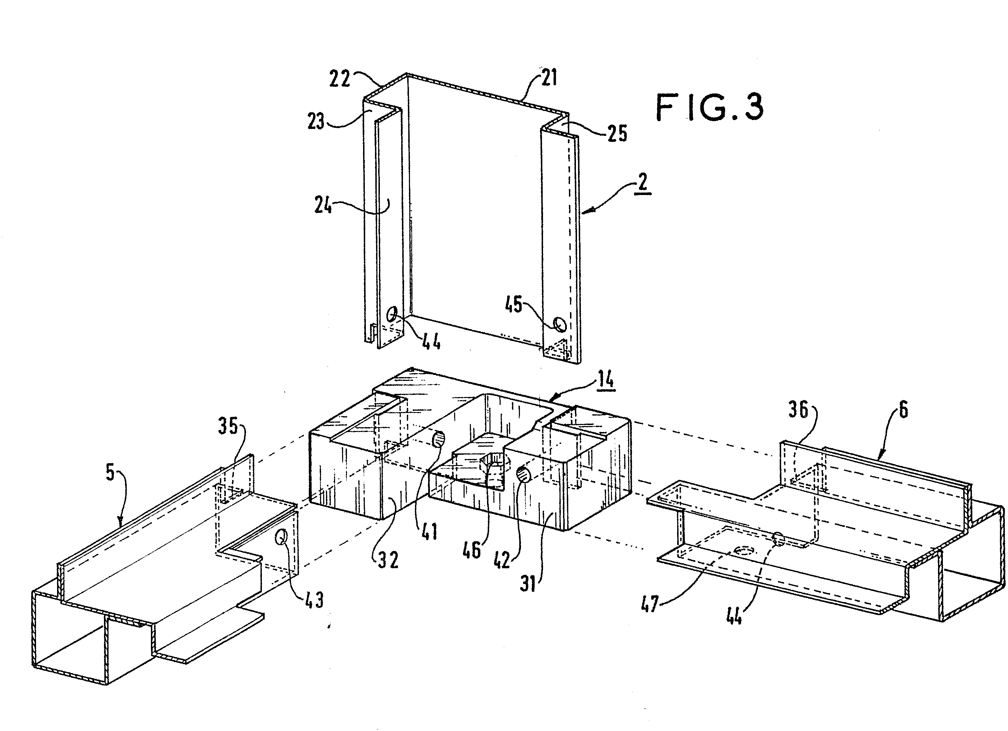

En se reportant à la figure 3, on voit qu'un coin tel que 14 est constitué par un bloc comportant deux ailes perpendiculaires 31 et 32.

Une traverse telle que 6 vient s'emmancher sur l'aile 31 et une traverse 5 vient s'emmancher sur l'aile 32.

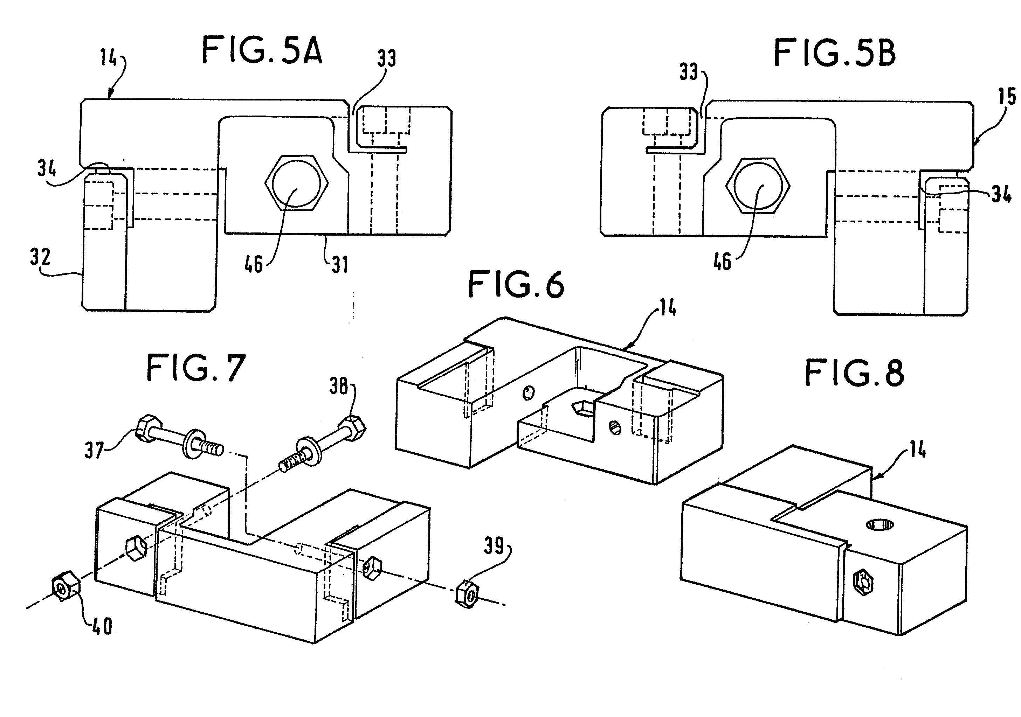

Le coin comporte en outre deux fentes 33 et 34 : la fente 33 sur l'aile 31 et la fente 34 sur l'aile 32. Ces deux fentes 33 et 34 sont en forme d'équerre dont une branche débouche pour chacune d'entre elles à l'extérieur du coin par rapport à l'angle droit intérieur formé par les deux ailes 31 et 32. Ces deux fentes sont bien visibles sur la figure 5A.

La figure 5B représente un coin symétrique du coin 14 tel que, par exemple, le coin 15 de la figure 1.

La figure 9 montre que le premier côté 21 du montant 2 longe la face extérieure de l'aile 31, que le deuxième côté 22 longe la face extérieure de l'aile 32, que les troisième et quatrième côtés 23 et 24 pénètrent dans la fente 34 et que les cinquième et sixième côtés 25 et 26 pénètrent dans la fente 33.

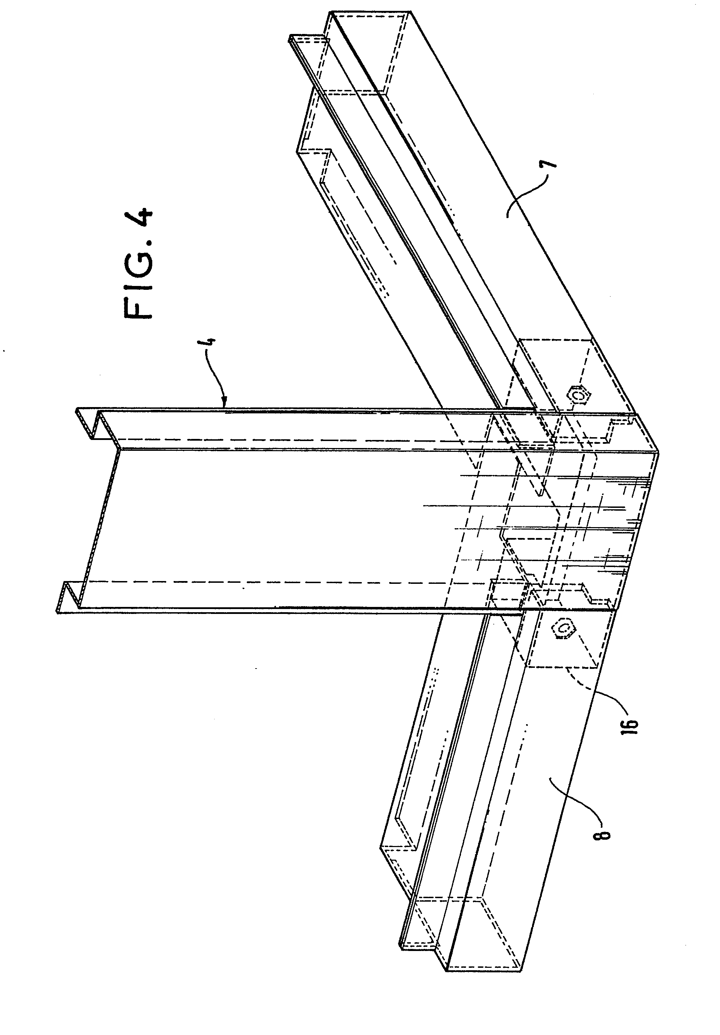

Par ailleurs, lors de l'assemblage, le quatrième côté 24 du montant vertical pénètre dans une fente 35 de la traverse horizontale 5 et de même le sixième côté 26 pénètre dans une fente 36 de la traverse horizontale 6 (voir figure 3) réalisant ainsi un enchevêtrement au moins partiel de chaque traverse avec le montant, comme on le voit bien sur la figure 9. L'ensemble est alors fixé au moyen de deux vis 37 et 38 (figures 7 et 9). La vis 37 traverse la traverse 5, l'aile 32 et le quatrième côté 24 du montant vertical et vient se visser dans un écrou 39. De même, la vis 38 traverse la traverse 6, l'aile 31 et le sixième côté 26 du montant vertical et vient se visser dans un écrou 40. Comme on le voit sur la figure 3, l'extrémité de la traverse 5 s'emmanchant sur l'aile 32 du coin 14, de même que l'extrémité de la traverse 6 et que l'extrémité du montant vertical 2, comportent des découpes de telle sorte qu'une fois l'assemblage réalisé, les trois faces du trièdre soient lisses, sans dénivellation comme le montre la figure 4. A cet effet également, les coins d'assemblage, comme on le voit bien sur les figures 3, 6, 7 et 8 portent des lamages.

Comme il a été dit, les coins d'assemblage au nombre de huit comportent quatre coins identiques et les quatre autres étant symétriques des quatre premiers par rapport à l'une quelconque de leurs faces. Sur la figure 1, deux coins adjacents sont symétriques si bien que les découpes réalisées aux extrémités des traverses et des montants sont également symétriques par rapport à un plan coupant perpendiculairement ces éléments en leur milieu. Sur les figures, les découpes n'ont été représentées qu'à une seule des extrémités, celle où l'assemblage a été montré.

Pour le passage des vis 37 et 38, les coins d'assemblage portent des trous 41 et 42 (figure 3), la traverse 5 un trou 43, la traverse 6 un trou 44 et les quatrième et sixième côtés 24 et 26 des montants verticaux des trous 44 et 45.

De même, pour la fixation au sol et pour la fixation d'anneaux d'attache d'élingues pour les transports, les coins d'assemblage comportent des trous 46 et les traverses telles que 6, s'emmanchant dans l'aile 31 des coins d'assemblage sont percées à leurs extrémités d'un trou 47.

Selon la même conception d'assemblage, on peut prévoir dans le cas d'une armoire de grande largeur des montants et traverses intermédiaires assemblés sur des coins à trois branches dans un même plan. On a alors un cadre intermédiaire comportant deux montants verticaux, deux traverses

0129056

horizontales et quatre coins d'assemblage à trois branches réunissant chacun un montant vertical à trois traverses horizontales, la fixation étant réalisée au moyen de trois vis dont l'une relie une traverse intermédiaire avec une branche d'un coin, une autre relie un côté latéral d'un montant vertical pénétrant dans une fente en équerre d'une seconde branche du coin avec une demi traverse principale et une troisième relie le côté latéral opposé du montant vertical pénétrant également dans une fente en équerre d'une troisième branche du coin dans le prolongement de la seconde, avec une demi traverse principale prolongeant l'autre demi traverse.

La figure 14 représente une variante possible d'un bloc d'assemblage. Celui représenté sur cette figure 14 correspond par exemple au bloc 14 tel que représenté figure 5A. Les autres blocs homologues c'est-à-dire les blocs 16, 17 et 19 peuvent donc être identiques à ce bloc représenté sur cette figure 14 et les autres c'est-à-dire les blocs 13, 15, 18 et 20 sont symétriques de celui-ci par rapport à une quelconque de ses faces.

Dans cette variante, le bloc d'assemblage a la forme générale d'un parallélépipède rectangle, possédant, comme les blocs en forme d'équerre, des fentes en forme d'équerre 33 et 34 pour l'enfichage d'un montant tel que 2. Une traverse 6 peut s'emmancher dans l'extrémité repérée 48 et une traverse 5 peut s'emmancher perpendiculairement à l'autre extrémité, repérée 49, en pénétrant dans une fente 50 du bloc.

Le bloc 14 comprend un trou 46 rectangulaire comportant des épaulements 51 et 52 sur ses deux grands côtés de manière à pouvoir passer une noix de serrage et à la maintenir après rotation d'un quart de tour. Ceci permet de fixer un anneau d'élingage démontable et remontable par l'extérieur.

L'invention englobe, outre les réalisations décrites ci-dessus, des variantes :
Ainsi les traverses peuvent présenter un autre porfil tel qu'un profil non-creux. Dans ce cas les blocs présentent des orifices dans lesquels pénètrent les extrémités des traverses.

REVENDICATIONS

1/ Dispositif d'assemblage en coin, de deux traverses (5, 6) disposées perpendiculairement et d'un montant (2) perpendiculaire au plan formé par les deux traverses, au moyen d'un bloc d'assemblage (14), caractérisé en ce que l'une (6) des traverses s'emmanche dans une extrémité du bloc d'assemblage, l'autre (5) traverse s'emmanchant perpendiculairement dans une autre extrémité du bloc d'assemblage, ledit montant s'enfichant dans ledit bloc dans deux fentes (33, 34) dudit bloc, chaque fente ayant une forme d'équerre dont l'une des branches débouche à l'extérieur du bloc, la branche débouchant à l'extérieur du bloc, des deux fentes, débouchant respectivement sur deux parois perpendiculaires du bloc, la section dudit montant se composant, au niveau de son enfichage dans le bloc, de six côtés dont un premier côté (21) longe une face dudit bloc, un second côté (22), perpendiculaire au premier, longe une autre face dudit bloc, un troisième côté (23) perpendiculaire au second côté, un quatrième côté (24) perpendiculaire au troisième côté, les troisième et quatrième côtés pénétrant dans l'une (34) desdites fentes du bloc, un cinquième côté (25) adjacent au premier côté, du côté opposé au second côté, parallèle à ce second côté et un sixième côté (26) perpendiculaire au cinquième côté, les cinquième et sixième côtés pénétrant dans l'autre (33) desdites fentes du bloc, ladite section du montant réalisant un enchevêtrement au moins partiel avec chacune des deux traverses, l'ensemble étant maintenu au moyen de deux boulons (37, 38) dont l'un (38) pénètre dans une traverse (6), le bloc et ledit sixième côté (26) du montant et l'autre (37) pénètre dans l'autre traverse (5), le bloc et ledit quatrième côté (24) du montant.

2/ Dispositif d'assemblage selon la revendication 1, caractérisé en ce que ledit bloc d'assemblage comporte deux ailes perpendiculaires (31, 32) dans lesquelles viennent respectivement s'emmancher les deux dites traverses.

3/ Dispositif d'assemblage selon la revendication 1, caractérisé en ce que ledit bloc d'assemblage a la forme générale d'un parallélépipède rectangle, l'une (6) des traverses s'emmanchant en bout à l'une de ses extrémités et l'autre (5) traverse s'emmanchant perpendiculairement à l'autre extrémité grâce à une fente (50) pratiquée dans le bloc perpendiculairement à sa plus grande longueur (figure 14).

4/ Dispositif d'assemblage selon l'une des revendications 2 ou 3, caractérisé en ce que les deux traverses ont une même section constituant un profil creux fermé.

5/ Armoire comportant une ossature composée de huit traverses (5 à 12) dont quatre de fronton (9 à 12) et quatre de socle (5 à 12), de quatre montants verticaux (1 à 4) et de huit blocs d'assemblage (13 à 20), caractérisée en ce que ladite ossature est assemblée conformément au dispositif selon l'une des revendications 1 à 4.

6/ Armoire selon la revendication 5, caractérisée en ce que quatre (14, 16, 17, 19) desdits coins sont identiques et en ce que les quatre autres (13, 15, 18, 20), identiques entre eux, sont symétriques des quatre premiers par rapport à une quelconque de leurs faces.

0129056

FIG.1

FIG.2

# FIG.3

FIG. 4

FIG.5A

FIG.5B

FIG.6

FIG.7

FIG.8

5/7

0129056

0129056

FIG.9

FIG.12

FIG.10

FIG.11

FIG.13

FIG.14

Office européen
des brevets

**RAPPORT DE RECHERCHE EUROPEENNE**

EP 84 10 5486

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| Y | US-A-3 265 419 (J.A. DURNBAUGH et al.) <br> * En entier * | 1,2,3, 5,6 | H 05 K 7/18 <br> F 16 B 12/50 |
| Y | FR-A-2 332 486 (ATELIERS DE CONSTRUCTIONS ELECTRIQUES DE CHARLEROI [ACEC]) <br> * En entier * | 1,5,6 | |
| Y | DE-A-1 554 238 (GENERAL ELECTRIC CO.) <br> * Pages 5-9; figures * | 1-3 | |
| Y | US-A-4 361 369 (A. ZWILLICH) <br> * Résumé; revendications 1,11; figures 1,2,18-22 * | 1-6 | |
| D,A | FR-A-2 040 976 (F. GROSS) <br> * En entier * | 1-3 | **DOMAINES TECHNIQUES RECHERCHES (Int. Cl. 3)** <br><br> H 05 K <br> F 16 B |
| A | DE-B-1 264 553 (SIEMENS AG) <br> * Revendication 1; figure 1 * | 1,2,5 | |

Le présent rapport de recherche a été établi pour toutes les revendications

| Lieu de la recherche | Date d'achèvement de la recherche | Examinateur |
|---|---|---|
| LA HAYE | 10-08-1984 | VISENTIN A. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82